(19) **Europäisches Patentamt**

**European Patent Office**

**Office européen des brevets**

(11) **EP 1 133 036 A2**

(12) # EUROPEAN PATENT APPLICATION

(43) Date of publication:
**12.09.2001 Bulletin 2001/37**

(51) Int Cl.7: **H01S 5/14**

(21) Application number: **01105908.6**

(22) Date of filing: **09.03.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **10.03.2000 JP 2000067472**

(71) Applicant: **Sumitomo Electric Industries, Ltd.**
**Osaka-shi, Osaka 541-0041 (JP)**

(72) Inventors:
• **Nakaya, Hiroyuki,**
**c/o Sumitomo Electric Ind., Ltd.**
**Yokohama-shi, Kanagawa 244-8588 (JP)**

• **Miki, Atsushi, c/o Sumitomo Electric Ind., Ltd.**
**Yokohama-shi, Kanagawa 244-8588 (JP)**
• **Shigehara, Masakazu,**
**c/o Sumitomo Electr.Ind.,Ltd.**
**Yokohama-shi, Kanagawa 244-8588 (JP)**
• **Sasaki, Goro, c/o Sumitomo Electric Ind., Ltd.**
**Yokohama-shi, Kanagawa 244-8588 (JP)**

(74) Representative: **Grünecker, Kinkeldey,**
**Stockmair & Schwanhäusser Anwaltssozietät**
**Maximilianstrasse 58**
**80538 München (DE)**

(54) **Semiconductor laser module**

(57) A semiconductor laser module has a semiconductor light-emitting device and an optical fiber provided with a diffraction grating. The diffraction grating is a chirped grating having a refractive index with a period continuously changing along the optical axis direction (light-guiding direction) of optical fiber, whereas the amplitude of refractive index of the chirped grating changes so as to draw an envelope (apodization curve) along the light-guiding direction. The period of refractive index of chirped grating becomes the shortest on the side closer to the semiconductor light-emitting device and successively expands along the propagating direction of laser light (light-guiding direction). Consequently, the reflection spectrum characteristic of diffraction grating mildly changes with a single peak in a region having a width not narrower than the half width of reflection spectrum, whereby a plurality of peaks are restrained from occurring in the reflection spectrum characteristic.

**Fig.1**

EP 1 133 036 A2

**Description**

<u>BACKGROUND OF THE INVENTION</u>

<u>Field of the Invention</u>

The present invention relates to a semiconductor laser module for outputting laser light.

<u>Related Background Art</u>

As a semiconductor laser module for outputting laser light, there has been one in which an optical fiber provided with a diffraction grating is disposed at a predetermined distance from a semiconductor light-emitting device. In the semiconductor light-emitting device of this semiconductor laser module, an active region is formed between cladding layers, whereas end faces of the active region are provided with a light-emitting surface and a light-reflecting surface, respectively. The light-emitting surface faces the optical fiber and is formed as a low-reflecting surface exhibiting a low reflectivity with respect to light. The light-reflecting surface is formed opposite the light-emitting surface as a high-reflecting surface exhibiting a high reflectivity with respect to light. On the other hand, the optical fiber is provided with a diffraction grating in which a plurality of regions having a high refractive index are formed at a predetermined period in a core which acts as a light-guiding line. This optical fiber is disposed at a predetermined distance from the semiconductor light-emitting device on the light-emitting surface side. The semiconductor laser module generates light at the active region when current is injected into the semiconductor light-emitting device, amplifies the light by reflecting it between the light-reflecting surface and the diffraction grating, and outputs by way of the optical fiber a single wavelength of laser light determined by the diffraction grating which has a predetermined period of refractive index. The semiconductor laser module having the above-mentioned configuration is suitably used as a pumping light source for an optical amplifier or Raman amplifier or the like requiring a high output in particular.

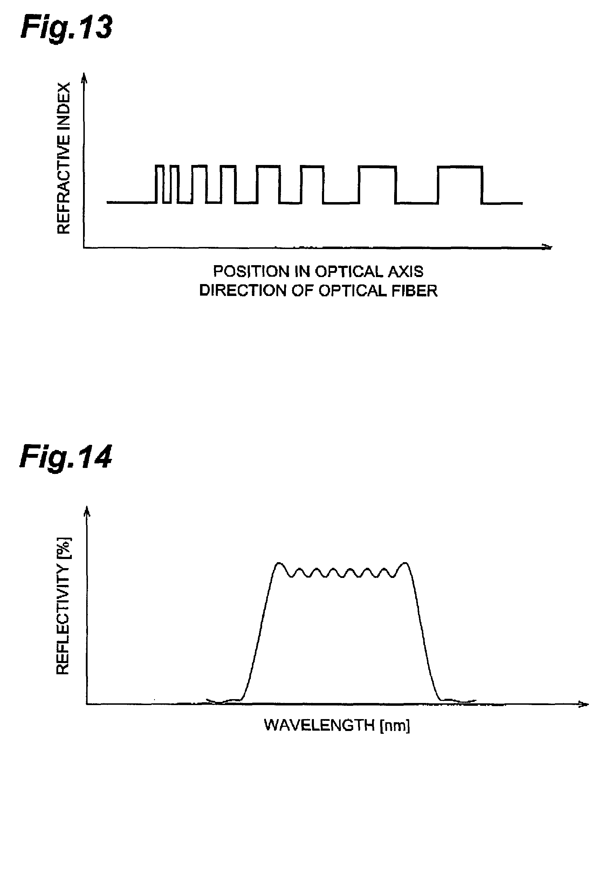

As the semiconductor laser module mentioned above, one disclosed in Japanese Patent Application Laid-Open No. HEI 10-293234 has been known, for example. The semiconductor laser module disclosed in Japanese Patent Application Laid-Open No. HEI 10-293234 comprises a semiconductor light-emitting device for emitting light, a package for containing the semiconductor light-emitting device, an optical fiber provided with a diffraction grating for reflecting only a predetermined wavelength of light in the light emitted from the semiconductor light-emitting device, and a ferrule and a connector sleeve which connect the package to the optical fiber. This diffraction grating is a chirped grating in which the period of refractive index continuously changes as shown in Fig. 13.

<u>SUMMARY OF THE INVENTION</u>

It is an object of the present invention to provide, in a semiconductor laser module such as those mentioned above, one which can stabilize the optical output therefrom.

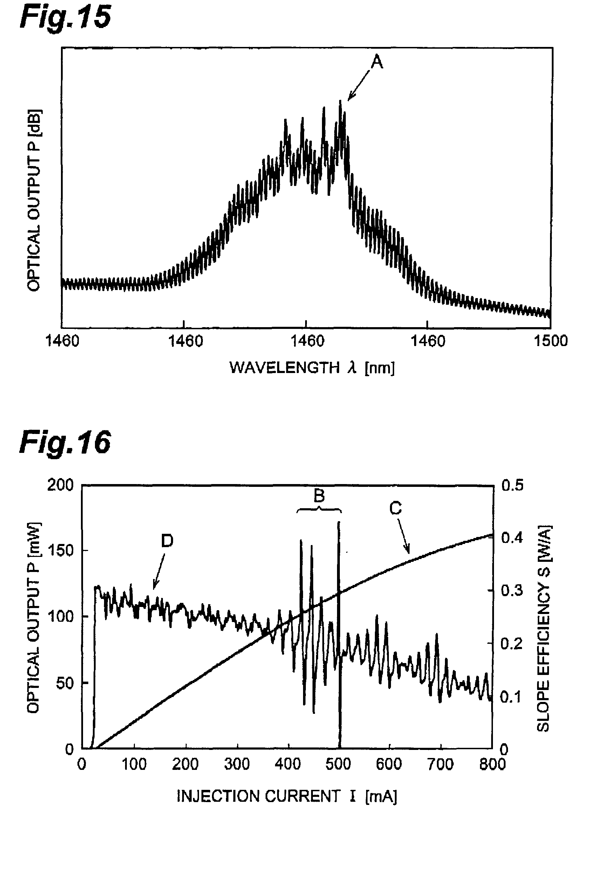

As a result of researches and studies, the inventors have newly found the following fact: If a chirped grating is employed as a diffraction grating, then the diffraction grating has a reflection spectrum characteristic which widens in a substantially trapezoidal form as shown in Fig. 14, whereby a plurality of longitudinal modes exist within an oscillation wavelength band of laser light. In the reflection spectrum characteristic of chirped grating, under the influence of sub-peaks included in side lobes in the reflection spectrum characteristic, a plurality of peaks exist in the reflection spectrum characteristic as shown in Fig. 14. Therefore, as shown in Fig. 15, a ripple (part A in Fig. 15) occurs in the oscillation spectrum of laser light.

Since the ripple is generated in the oscillation spectrum as mentioned above, mode hopping occurs as current is injected, whereby optical output changes greatly. Consequently, as shown in Fig. 16, a kink (B region) occurs in the injection current vs. optical output characteristic, whereby the optical output from the semiconductor laser module becomes unstable. In Fig. 16, characteristic C indicates the injection current vs. optical output characteristic, whereas characteristic D indicates the injection current vs. slope efficiency characteristic.

For achieving the above-mentioned object, the semiconductor laser module in accordance with the present invention comprises a semiconductor light-emitting device for emitting light, and an optical fiber provided with a diffraction grating for reflecting a predetermined wavelength of light in the light emitted from the semiconductor light-emitting device; wherein the semiconductor light-emitting device and the optical fiber are optically coupled to each other; wherein a light-reflecting surface of the semiconductor light-emitting device and the diffraction grating have a distance therebetween set to a coherence length of the light emitted from the semiconductor light-emitting device or shorter; wherein the diffraction grating is a chirped grating; and wherein the chirped grating has a refractive index with an amplitude apodized along a light-guiding direction.

In the semiconductor laser module in accordance with the present invention, since the diffraction grating is a chirped grating whereas the amplitude of refractive index of chirped grating is apodized along the light-guiding direction, the reflection spectrum characteristic of diffraction grating mildly changes with a single peak in a region having a width not narrower than the half width of reflection spectrum, thereby restraining a plurality of peaks from occurring in the reflection spectrum characteristic. As a consequence, even when the wavelength of a longitudinal mode of light resonating between the light-reflecting surface and light-emitting surface of semiconductor light-emitting device fluctuates due to a disturbance or the like, its influence upon the output of laser light oscillating according to the reflection spectrum characteristic of diffraction grating is so small that kinks are restrained from occurring in the injection current vs. optical output characteristic of the laser light. As a result, the optical output from the semiconductor laser module can be stabilized.

Here, the coherence length refers to the maximum optical path length difference at which interference fringes are obtained after two beams split from laser light are transmitted by respective optical path lengths different from each other and then are combined together in terms of wave front. When a diffraction grating whose refractive index changes at a constant period is used, a kink will occur in the injection current vs. optical output characteristic due to a favorable coherence if the distance between the light-reflecting surface of semiconductor light-emitting device and the diffraction grating is set to the coherence length of the light emitted from the semiconductor light-emitting device or shorter. If a chirped grating whose refractive index has an amplitude apodized along the light-guiding direction is used as in the present invention, however, then coherence can be lowered, whereby kinks can be restrained from occurring in the injection current vs. optical output characteristic.

In the semiconductor laser module in accordance with the present invention, the diffraction grating may have a reflection spectrum with a half width of at least 2 nm.

If the half width of reflection spectrum of the diffraction grating is at least 2 nm, then a plurality of longitudinal modes exist within the oscillation wavelength band of laser light. Therefore, even when these longitudinal modes fluctuate in terms of wavelength, their influence on the output of laser light is so small that kinks can be restrained from occurring in the injection current vs. optical output characteristic of the laser light.

In the semiconductor laser module in accordance with the present invention, the diffraction grating may have a reflection spectrum with a half width not greater than 6 nm.

If the half width of reflection spectrum of the diffraction grating is not greater than 6 nm, then an optimal oscillation line width can be obtained when combining wavelengths.

In the semiconductor laser module in accordance with the present invention, the diffraction grating may have a reflectivity of at least 1%.

If the diffraction grating has a reflectivity of at least 1%, then an oscillation at the Bragg wavelength of diffraction grating can be obtained.

In the semiconductor laser module in accordance with the present invention, the diffraction grating may be a chirped grating having a period of refractive index at a first position in the light-guiding direction greater than that at a second position which is closer to the semiconductor light-emitting device.

If the diffraction grating is a chirped grating having a period of refractive index at a first position in the light-guiding direction greater than that at a second position which is closer to the semiconductor light-emitting device, then ripples are restrained from occurring in the oscillation spectrum characteristic. As a consequence, kinks can be restrained from occurring in the injection current vs. optical output characteristic of laser light.

In the semiconductor laser module in accordance with the present invention, the optical fiber may be a polarization-maintaining optical fiber.

If the optical fiber is a polarization-maintaining optical fiber, then the state of polarization of light is maintained within a resonator formed between the semiconductor light-emitting device and diffraction grating. Therefore, the stability of optical output can be enhanced.

Also, polarized waves can be restrained from being disturbed within the resonator due to bending and twisting in the optical fiber part outside the resonator.

The semiconductor laser module in accordance with the present invention may further comprise connecting means for connecting a package to the optical fiber; the connecting means may include a ferrule, attached to the package, for holding the optical fiber; and the diffraction grating may be provided at a part of the optical fiber which is held within the ferrule.

In this case, the coupling efficiency between the optical fiber and semiconductor light-emitting device improves, whereby the optical output can be restrained from changing due to shocks such as vibrations.

In the semiconductor laser module in accordance with the present invention, the optical fiber may have a tip end face on the semiconductor light-emitting device side inclined by a predetermined angle from a plane perpendicular to the light-guiding direction.

If the tip end face of optical fiber on the semiconductor light-emitting device side is inclined by a predetermined angle from a plane perpendicular to the light-guiding direction, then reflection is suppressed at the tip end face of optical fiber on the semiconductor light-emitting device side. Therefore, the optical output from the tip end face of optical fiber to the semiconductor light-emitting device can be restrained from decreasing.

In the semiconductor laser module in accordance with the present invention, the tip end face of optical fiber on the semiconductor light-emitting device side may be coated with an antireflection film having a reflectivity of 1% or less.

If the tip end face of optical fiber on the semiconductor light-emitting device side is coated with an antireflection film having a reflectivity of 1% or less, then reflection of laser light is suppressed at the tip end face of optical fiber. Therefore, the optical output from the tip end face of optical fiber to the semiconductor light-emitting device can be restrained from decreasing.

In the semiconductor laser module in accordance with the present invention, the light-emitting surface of semiconductor light-emitting device may be coated with an antireflection film having a reflectivity of at least 0.05% but not exceeding 1%.

If the light-emitting surface of semiconductor light-emitting device is coated with an antireflection film having a reflectivity of at least 0.05% but not exceeding 1%, then laser light is restrained from being reflected at the light-emitting surface of semiconductor light-emitting device. Therefore, the decrease in optical output from the semiconductor light-emitting device to the optical fiber can be suppressed.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

BRIEF DESCRIPTION OF THE DRAWINGS

Fig. 1 is a schematic longitudinal sectional view of the semiconductor laser module in accordance with an embodiment of the present invention;

Fig. 2 is a schematic view of a semiconductor light-emitting device included in the semiconductor laser module in accordance with the embodiment of the present invention;

Fig. 3 is a schematic view of an optical fiber included in the semiconductor laser module in accordance with the embodiment of the present invention;

Fig. 4 is a graph showing the relationship between the reflectivity of antireflection film for the semiconductor light-emitting device and the optical output from the semiconductor light-emitting device in the semiconductor laser module in accordance with the embodiment of the present invention;

Fig. 5 is a graph showing the relationship between the angle formed between a plane perpendicular to the optical axis direction of optical fiber and the tip end face of optical fiber and the return loss at the tip end face of optical fiber in the semiconductor laser module in accordance with the embodiment of the present invention;

Fig. 6 is a graph showing the relationship between the angle formed between the plane perpendicular to the optical axis direction of optical fiber and the tip end face of optical fiber and the amount of axial offset of a second lens in the semiconductor laser module in accordance with the embodiment of the present invention;

Fig. 7 is a graph showing the refractive index distribution of a diffraction grating included in the semiconductor laser module in accordance with the embodiment of the present invention;

Fig. 8 is a graph showing the reflection spectrum characteristic of the diffraction grating included in the semiconductor laser module in accordance with the embodiment of the present invention;

Fig. 9 is a graph showing the relationship between the reflectivity of diffraction grating and the optical output from the diffraction grating to the semiconductor light-emitting device in the semiconductor laser module in accordance with the embodiment of the present invention;

Fig. 10 is a graph showing the relationship between the half width of reflection spectrum of the diffraction grating and the oscillation line width in the semiconductor laser module in accordance with the embodiment of the present invention;

Fig. 11 is a graph showing an oscillation spectrum characteristic as an example of characteristics of the semiconductor laser module in accordance with the embodiment of the present invention;

Fig. 12 is a graph showing an injection current vs. optical output characteristic and an injection current vs. slope efficiency characteristic as examples of characteristics of the semiconductor laser module in accordance with the embodiment of the present invention;

Fig. 13 is a graph showing the refractive index distribution of a diffraction grating (chirped grating) included in a conventional semiconductor laser module;

Fig. 14 is a graph showing the reflection spectrum characteristic of the diffraction grating (chirped grating) included in the conventional semiconductor laser module;

Fig. 15 is a graph showing an oscillation spectrum characteristic as an example of characteristics of the conventional semiconductor laser module; and

Fig. 16 is a graph showing an injection current vs. optical output characteristic and an injection current vs. slope efficiency characteristic as examples of characteristics of the conventional semiconductor laser module.

DESCRIPTION OF THE PREFERRED EMBODIMENTS

In the following, preferred embodiments of the semiconductor laser module in accordance with the present invention will be explained in detail with reference to the drawings. In the explanation of drawings, constituents identical to each other will be referred to with numerals or letters identical to each other without repeating their overlapping descriptions.

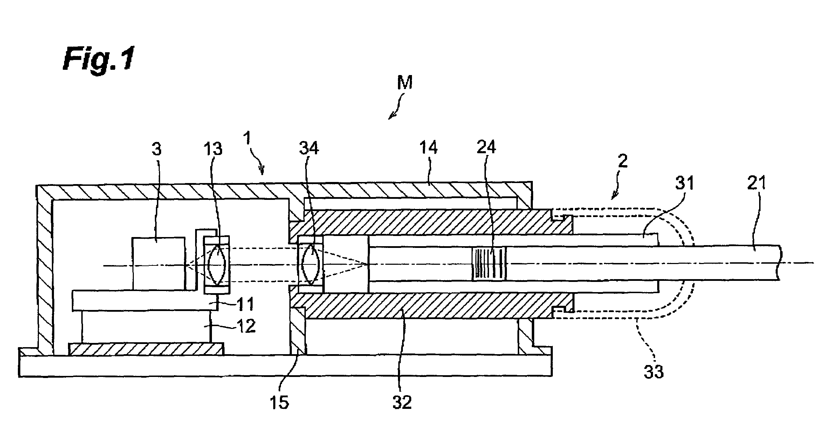

A semiconductor laser module M comprises a package 1 and a diffraction grating connector 2 as shown in Fig. 1. The package contains a semiconductor light-emitting device 3, which is mounted on a chip carrier 11.

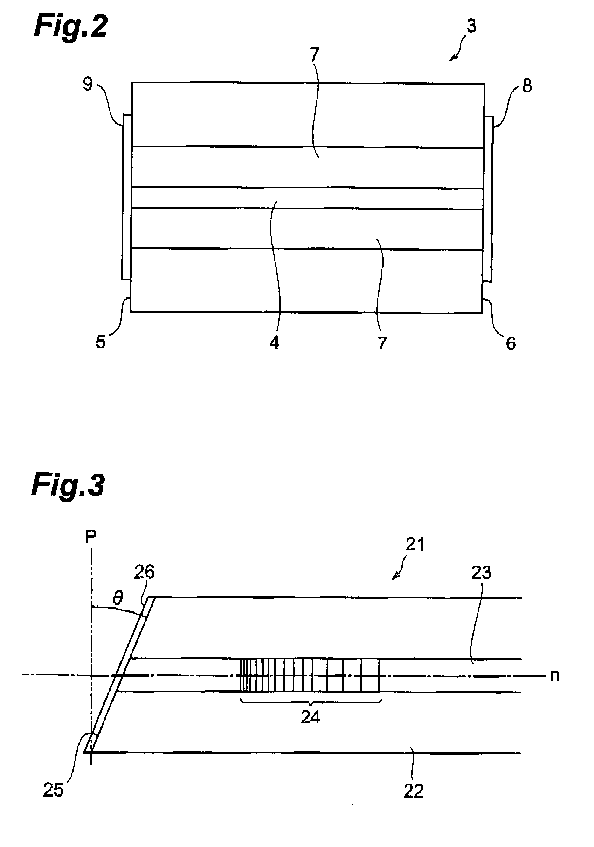

As shown in Fig. 2, the semiconductor light-emitting device 3 has an active region 4 for generating and amplifying light. The semiconductor light-emitting device 3 is provided with a light-reflecting surface 5 and a light-emitting surface 6 which oppose each other across the active region 4. The semiconductor light-emitting device 3 generates and amplifies light when current is injected into the active region 4, reflects the light at the light-reflecting surface 5, and emits the light from the light-emitting surface 6. As the semiconductor light-emitting device 3, a Fabry-Perot type semiconductor chip of InGaAsP/InP double heterostructure is used, for example, in which an active region made of InGaAsP is disposed between cladding layers made of InP. Also, as the semiconductor light-emitting device 3, one having an oscillation wavelength for 1.48-$\mu$m band is used, for example. In this case, the semiconductor laser module M can be utilized as a pumping light source for an optical amplifier.

As current injecting means in the semiconductor light-emitting device 3, one in which a driving circuit (not depicted) for current injection is connected to the semiconductor light-emitting device 3 is employed, for example, as long as it has such a structure that current can flow into the active region 4 through cladding layers 7, 7. If a predetermined current is injected from such a driving circuit into the semiconductor light-emitting device 3, then its p-n junction structure including the active region 4 generates population inversion. Triggered by spontaneously emitted light, the active region 4 emits light amplified upon stimulated emission, whereby the spontaneously emitted light and stimulatingly emitted light are emitted from the light-emitting surface 6. Here, the semiconductor light-emitting device 3 is not restricted to the above-mentioned InGaAsP/InP double heterostructure, but may be formed by other semiconductors and the like as long as it can generate and amplify light and has the above-mentioned light-reflecting surface 5 and light-emitting surface 6. Also, the semiconductor light-emitting device 3 is not restricted to the one for 1.48-$\mu$m band, and may oscillate laser light at other wavelengths as well.

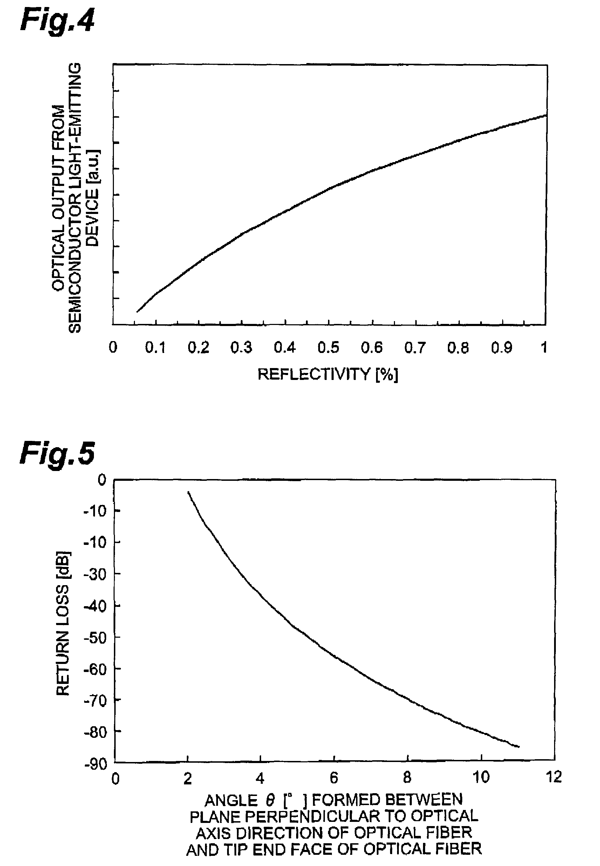

The light-emitting surface 6 of semiconductor light-emitting device 3 is coated with an antireflection film, so that its light reflectivity is very low. As the antireflection film for the light-emitting surface 6, a dielectric multilayer film 8 is used, for example. The dielectric multilayer film 8 is constructed by lamination of thin films made of silica ($SiO_2$), silicon nitride ($Si_3N_4$), aluminum oxide ($Al_2O_3$), amorphous silicon, and the like, and can arbitrarily set the light reflectivity at a specific wavelength by changing the refractive index of material of each film, thickness thereof, and the number of layers as appropriate. It is desirable that the antireflection film (dielectric multilayer film 8) of light-emitting surface 6 have a light reflectivity of at least 0.05% but not exceeding 1%. At such a light reflectivity, laser light can be restrained from being reflected at the light-emitting surface 6 of semiconductor light-emitting device 3, whereby the decrease in optical output from the semiconductor light-emitting device 3 to the optical fiber 21 can be suppressed as shown in Fig. 4. In this embodiment, the thickness of dielectric multilayer film 8 is set to about 0.3 $\mu$m which is $\lambda$/4.

On the light-reflecting surface 5 side, by contrast, the semiconductor light-emitting device 3 has a very high light reflectivity at the oscillation wavelength. This embodiment attains a high light reflectivity by forming the light-reflecting surface 5 with a dielectric multilayer film 9 similar to that for the light-emitting surface 6.

Referring to Fig. 1 again, the chip carrier 11 is secured to the bottom bed of package 1 by way of cooling means 12, for example. The cooling means 12 is constituted by a heat dissipating device such as Peltier effect device, for example, and imparts an appropriate heat dissipating function to the semiconductor 3 when driven.

If necessary, a first lens 13 known as "collimator lens" is disposed within the package 1. The first lens 13 is supported on the chip carrier 11 such that its optical axis aligns with the semiconductor light-emitting device 3 on the emitted light side.

In the semiconductor laser module M, as shown in Fig. 1, the casing 14 of package 1 is elongated, whereas the diffraction grating connector 2 enters the elongated portion so as to be disposed within the package 1. The diffraction grating connector 2 has an optical fiber 21, a ferrule 31, and a connector sleeve 32. The optical fiber 21 is inserted into the ferrule 31. The ferrule 31 is made of a metal and is stably secured to the casing 14 and inner wall 15 (package 1). The main function of ferrule 31 is to provide connecting means for supporting the optical fiber 21 such that the optical fiber 21 is optically coupled to the semiconductor light-emitting device 3, and protecting means for protecting the optical fiber 21 against external stress. Also, the diffraction grating connector 2 as a whole is supported and protected by a connector cover 33 which is indicated by broken lines.

In the optical path between the optical fiber 21 and first lens 13, necessary optical elements such as a second lens 34 for collecting light are disposed. If necessary, all or part of these optical elements may be disposed on the package 1 side or diffraction grating connector 2 side. In the example shown in Fig. 1, the second lens 34 is disposed within the connector sleeve 32 so as to align with the optical axis of laser light emitted from the semiconductor light-emitting device 3. As a consequence, the light emitted from the semiconductor light-emitting device 3 is guided toward the diffraction grating connector 2 (optical fiber 21) by way of the first lens 13 and second lens 34.

In the optical fiber 21, as shown in Fig. 3, a core 23 having a high refractive index is formed along the center position of a cladding 22. In the part of optical fiber 21 held within the ferrule 31, at least the core 23 is provided with a diffraction grating 24 for reflecting a specific wavelength of light. Since the ferrule 31 is made of a metal whereas the diffraction grating 24 is disposed at the part of optical fiber 21 held within the ferrule 31, the optical fiber 21 can be packaged with a high precision. As a result, the coupling efficiency between the optical fiber 21 and semiconductor light-emitting device 3 can improve, thereby restraining optical output from changing due to shocks such as environmental temperature changes and vibrations.

Preferably, a polarization-maintaining optical fiber is used as the optical fiber 21. If a polarization-maintaining optical fiber is used as such, so that the plane of polarization of the light propagating through the polarization-maintaining optical fiber and the plane of polarization of the light emitted from the semiconductor light-emitting device 3 align with each other, then the state of polarization of light within the resonator formed between the semiconductor light-emitting device 3 and diffraction grating 24 is maintained, whereby the stability of optical output can be enhanced. Also, polarized waves can be restrained from being disturbed within the resonator due to bending and twisting in the optical fiber part outside the resonator.

A tip end face 25 of the optical fiber 21 on the semiconductor light-emitting device 3 side is provided with an antireflection coating (AR coating), so as to yield a very low light reflectivity. As the antireflection coating for the tip end face 25, a dielectric multilayer film 26 having a thickness of 0.7 $\mu$m in which four layers of $TiO_2 + SiO_2$ are laminated by IAD method is used, for example. The dielectric multilayer film 26 can variably set the light reflectivity at a specific wavelength by changing the refractive index of material of each film, thickness thereof, and the number of layers as appropriate. It is desirable that the antireflection coating for the tip end face 25 have a light reflectivity of 1% or less. At such a light reflectivity, laser light can be restrained from being reflected at the tip end face 25 of optical fiber 21, whereby the decrease in optical output from the tip end face 25 of optical fiber 21 to the semiconductor light-emitting device 3 can be suppressed.

The tip end face 25 of optical fiber 21 is obliquely ground so as to yield a predetermined angle $\theta$ from a plane p perpendicular to the optical axis direction (light-guiding direction) n of optical fiber 21. Since the tip end face 25 of optical fiber 21 is obliquely ground so as to yield the predetermined angle $\theta$ from the plane p perpendicular to the optical axis direction (light-guiding direction) n of optical fiber 21 as such, it can restrain laser light from being reflected at the tip end face 25 of optical fiber 21, thereby suppressing the decrease in op-

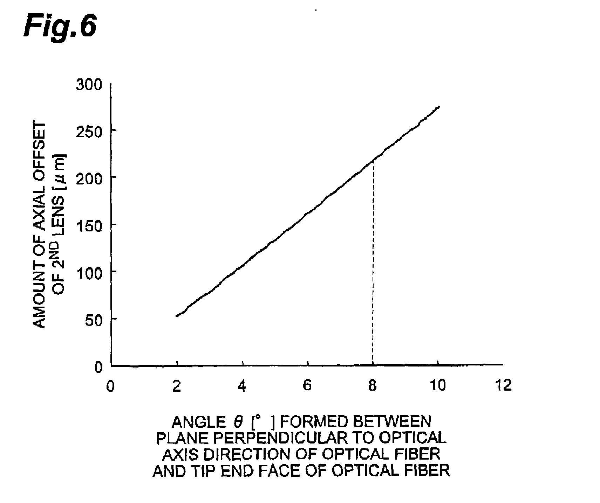

tical output. The angle $\theta$ formed between the plane perpendicular to the optical axis direction (light-guiding direction) n and the tip end face 25 of optical fiber 21 is preferably set $4° \leq \theta \leq 8°$. If the angle $\theta$ is set $\theta \geq 4°$, then the decrease in optical output can further be suppressed as shown in Fig. 5. If the angle $\theta$ is set $\theta \leq 8°$, then the coupling loss of optical fiber 21 can be lowered. If the angle $\theta$ is set $\theta > 8°$, then the amount of axial offset between the second lens 34 and optical fiber 21 becomes greater as shown in Fig. 6, whereby the coupling efficiency between the optical fiber 21 and semiconductor light-emitting device 3 deteriorates.

It will be sufficient if interference exposure method is used for providing the optical fiber 21 with the diffraction grating 24. Namely, interfering ultraviolet rays are emitted toward the core 23 doped with germanium from outside the optical fiber 21, whereby the core 23 is provided with a diffraction grating having a refractive index corresponding to the light intensity distribution of interference of ultraviolet rays. Though the diffraction grating 24 is disposed at a predetermined distance from the tip end face 25 of optical fiber 21 in Figs. 1 and 3, it may directly be disposed from the tip end face 25 of optical fiber 21 with no distance therebetween.

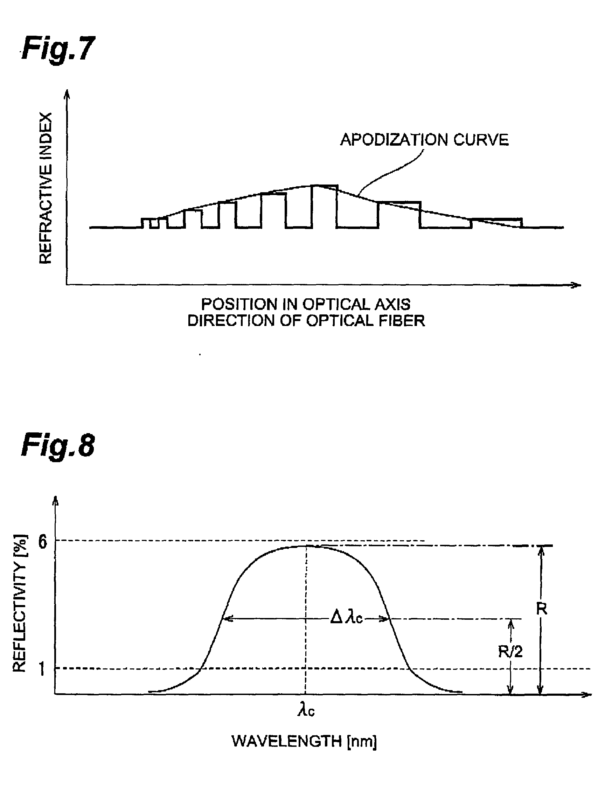

The diffraction grating 24 constitutes a Fabry-Perot type resonator together with the light-reflecting surface 5 of semiconductor light-emitting device 3, and is provided by periodically changing the refractive index of core 23 along the optical axis direction of optical fiber 21. The reflection wavelength characteristic of light is set according to the period of refractive index. Here, the diffraction grating 24 is a chirped grating in which the period of refractive index therein continuously changes. A chirped grating is a grating in which the period of refractive index change in the light-guiding direction of fiber, i.e., the grating period, is continuously changed in the light-guiding direction as shown in Fig. 7. In other words, the grating period is not constant but gradually changes. As a consequence, the wavelength of reflected light can be changed continuously from one having a short grating period to one having a long grating period.

The amplitude of refractive index of this chirped grating (diffraction grating 24) is apodized along the light-guiding direction, and changes so as to draw an envelope (apodization curve) as shown in Fig. 7. The envelope herein includes any of triangular and Gaussian ones.

As shown in Figs. 1 and 7, the period of refractive index of chirped grating (diffraction grating 24) becomes the shortest on the side closer to the semiconductor light-emitting device 3 (light-entrance-side end face 25 of optical fiber 21) and successively expands along the propagating direction of laser light (light-guiding direction) such that the period of refractive index at a first position in the light-guiding direction is greater than that at a second position which is closer to the semiconductor light-emitting device 3.

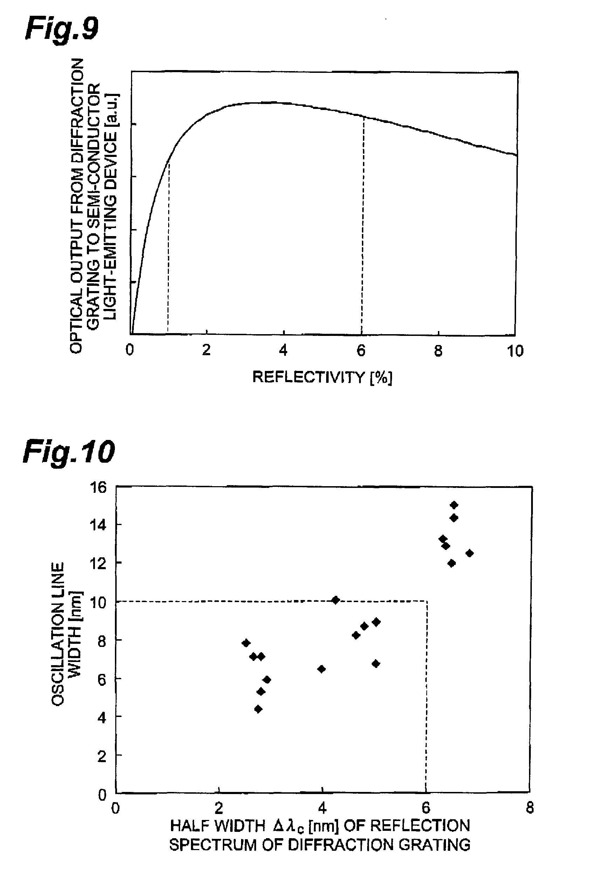

As shown in Fig. 8, the diffraction grating 24 has such a reflection spectrum characteristic that the reflection bandwidth of diffraction grating 24 becomes at least 2 nm but not exceeding 6 nm. The reflection bandwidth of diffraction grating 24 is set greater than the wavelength interval of longitudinal modes of the light resonating between the light-reflecting surface 5 and light-emitting surface 6 of semiconductor light-emitting device 3, whereby a plurality of longitudinal modes exist within the oscillation wavelength band of laser light.

In the reflection wavelength band region, as shown in Fig. 8, the reflection spectrum characteristic of diffraction grating 24 changes mildly with a single peak at a center wavelength $\lambda_c$, whereby a plurality of peaks are restrained from occurring in the reflection spectrum characteristic. Since the reflection spectrum characteristic of diffraction grating 24 mildly changes with a single peak (center wavelength $\lambda_c$), even when the wavelength of a longitudinal mode of light resonating between the light-reflecting surface 5 and light-emitting surface 6 of semiconductor light-emitting device 3 fluctuates due to a disturbance or the like, its influence upon the output of laser light oscillating according to the reflection spectrum characteristic of diffraction grating 24 is so small that kinks are restrained from occurring in the injection current vs. optical output characteristic of the laser light. As a result, the optical output from the semiconductor laser module M can be stabilized. Here, the reflection bandwidth of diffraction grating 24 refers to the wavelength region, centered at the wavelength (center wavelength $\lambda_c$) of light reflected at the maximum by the diffraction grating 24, between the shorter and longer wavelengths where the amount of reflection is reduced by half to R/2 from the maximum amount of reflection R, i.e., so-called half width $\Delta\lambda_c$ of diffraction grating 24, as shown in Fig. 8 when light is transmitted through the optical fiber 21 formed with the diffraction grating 24.

Since the reflection spectrum characteristic of diffraction grating 24 has a single peak at the center wavelength $\lambda_c$, in which longitudinal mode among a plurality of longitudinal modes existing within the oscillation wavelength band the laser light oscillates can be controlled in terms of design. As a consequence, the center wavelength of oscillation can be restrained from fluctuating among semiconductor laser modules M.

Also, the reflection spectrum characteristic of diffraction grating 24 widens, so that a plurality of longitudinal modes exist within the oscillation wavelength band of laser light, whereby a stabilized optical output oscillation spectrum can be obtained even when the distance between the semiconductor light-emitting device 3 and the diffraction grating 24 is shortened. On the other hand, since the diffraction grating 24 is disposed at a position within the package 1 and within the ferrule 31 (connector sleeve 32), the resonator formed within the optical fiber between the semiconductor light-emitting device 3 and the diffraction grating 24 is less susceptible to bending and twisting (torsion) upon a disturbance, so that a desirable state of polarization is obtained, whereby fluctuations in the output characteristic become smaller.

In the semiconductor laser module M, the distance (resonator length) between the light-reflecting surface 5 and the diffraction grating 24 is set to the coherence length of light emitted from the semiconductor light-emitting device 3 or shorter. Here, the coherence length refers to the maximum optical path length difference at which interference fringes are obtained after two beams split from laser light are transmitted by respective optical path lengths different from each other and then are combined together in terms of wave front. The coherence length $L_c$ is defined by the following expression:

$$L_c = \lambda^2/(2 \cdot \pi \cdot n \cdot \Delta\lambda)$$

where

$\lambda$ is the oscillation wavelength;
$n$ is the refractive index; and
$\Delta\lambda$ is the oscillation line width.

For example, if $\lambda$ = 0.85 μm, n = 1, and $\Delta\lambda$ = 1 pm, then $L_c$ = 11.5 cm. If $\lambda$ = 1.48 μm, n = 1, and $\Delta\lambda$ = 0.3 pm, then $L_c$ = 1.2 m.

When a diffraction grating whose refractive index changes at a constant period is used as the diffraction grating 24, a kink will occur in the injection current vs. optical output characteristic due to a favorable coherence if the distance between the. light-reflecting surface 5 of semiconductor light-emitting device 3 and the diffraction grating 24 is set to the coherence length of the light emitted from the semiconductor light-emitting device 3 or shorter-If a chirped grating whose refractive index has an amplitude apodized along the light-guiding direction is used as the diffraction grating 24 as in this embodiment, however, then coherence can be lowered, whereby kinks can be restrained from occurring in the injection current vs. optical output characteristic.

Preferably, the reflectivity $R_c$ of diffraction grating 24 and the half width $\Delta\lambda_c$ of reflection spectrum are selected so as to satisfy the following relationships:

$$R_c \geq 1\%.$$

Preferably,

$$1\% \leq R_c \leq 6\%.$$

If the reflectivity $R_c$ of diffraction grating 24 is at least 1%, then an oscillation at the Bragg wavelength of diffraction grating 24 can be obtained as shown in Fig. 9 unlike the case where the reflectivity $R_c$ is lower than that. If the reflectivity $R_c$ of diffraction grating 24 is not greater than 6%, then an optimal oscillation at the Bragg wavelength of diffraction grating 24 can be obtained.

Also,

$$\Delta\lambda_c \geq 2 \ nm.$$

Preferably,

$$2 \ nm \leq \Delta\lambda_c \leq 6 \ nm.$$

If the half width $\triangle\lambda_c$ of reflection spectrum of diffraction grating 24 is at least 2 nm, then a plurality of longitudinal modes exist within the oscillation wavelength band of laser light. Therefore, even when these longitudinal modes fluctuate in terms of wavelength, their influence on the state of oscillation of laser light is so small that nonlinearity (kink) is prevented from occurring in the injection current vs. optical output characteristic of the laser light. If the half width $\Delta\lambda_c$ of reflection spectrum of diffraction grating 24 is not greater than 6 nm, then an oscillation line width of 10 nm or less which is optimal for combining wavelengths can be obtained as shown in Fig. 10. Here, the oscillation line width refers to the line width at a position of -10 dB from the peak according to Envelope method.

Operations of the semiconductor laser module M will now be explained.

In Figs. 1 to 3, a predetermined voltage is applied between the cladding layers 7, 7 of semiconductor light-emitting device 3, so as to inject current into the active region 4. Consequently, the active region 4 is pumped, so as to generate spontaneously emitted light. This spontaneously emitted light induces stimulated emission within the active region 4 and advances together with the stimulatingly emitted light, and then is reflected by the light-reflecting surface 5 having a high reflectivity, so as to exit from the light-emitting surface 6 having a low reflectivity.

The light emitted from the light-emitting surface 6 toward the optical fiber 21 enters the core 23 of optical fiber 21 and advances along the core 23, so as to be reflected by the diffraction grating 24. Only a predetermined wavelength band of light reflected by the diffraction grating 24 advances toward the semiconductor light-emitting device 3, so as to exit from the tip end face 25 of optical fiber 21, thereby entering the active region 4 of semiconductor light-emitting device 3 by way of the light-emitting surface 6 thereof. The light advancing through the active region 4 is reflected by the light-reflecting surface 5 again while being amplified, and is amplified upon repeatedly traveling back and forth between the light-reflecting surface 5 and the diffraction grating 24 of optical fiber 21, thereby being transmitted through the diffraction grating 24 and outputted as desirable laser light. Since the reflection wavelength bandwidth of diffraction grating 24 is set wider than the wavelength interval of longitudinal modes in laser light, the oscillation spectrum of laser light has a band wider than the wavelength interval of longitudinal modes.

However, even when the wavelength of a longitudinal mode of light resonating between the light-reflecting surface 5 and light-emitting surface 6 of semiconductor light-emitting device 3 fluctuates due to a disturbance or the like, its influence upon the output of laser light oscillating according to the reflection spectrum characteristic of diffraction grating 24 is small, since the reflection spectrum characteristic of diffraction grating 24 changes mildly with a single peak in the reflection bandwidth region of diffraction grating 24. As a consequence, kinks can be restrained from occurring in the injection current vs. optical output characteristic of the laser light. Also, in which longitudinal mode among a plurality of longitudinal modes existing within the oscillation wavelength band the laser light oscillates can be controlled in terms of design, whereby the center wavelength of oscillation can be restrained from fluctuating among semiconductor laser modules M.

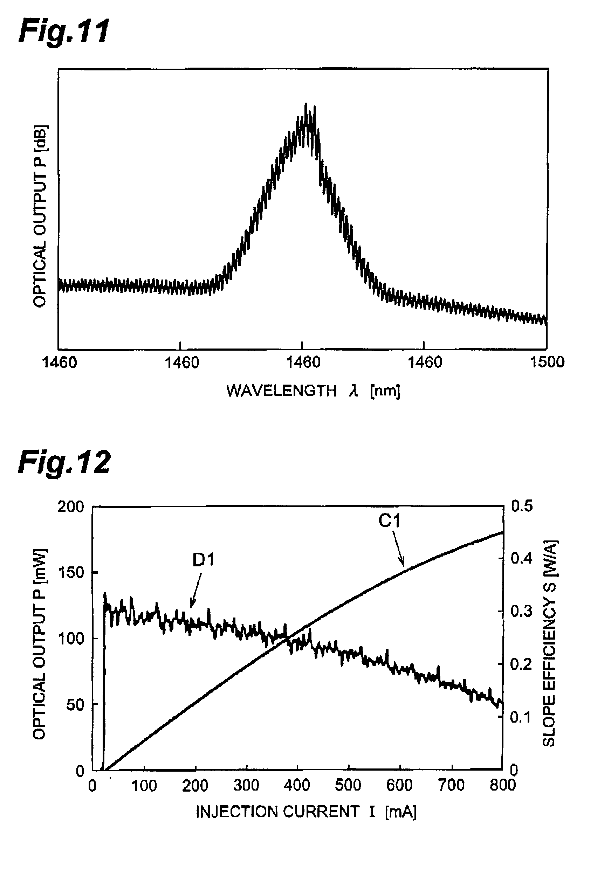

Fig. 11 shows the oscillation spectrum characteristic obtained when the semiconductor laser module M was actually operated. Fig. 12 shows its injection current vs. optical output characteristic and injection current vs. slope efficiency characteristic. As shown in Fig. 11, no ripples occurred in the semiconductor laser module M, whereby a stable oscillation spectrum characteristic was obtained. Also, as shown in Fig. 12, kinks were restrained from occurring in the optical output P in the semiconductor laser module M even when the injection current was gradually increased, whereby a stable optical output characteristic was obtained. The semiconductor laser module M used here is one in which a semiconductor light-emitting device for 1.48-$\mu$m band is employed as the semiconductor light-emitting device 3, the reflectivity $R_c$ of diffraction grating 24 is 3.5%, and the half width $\Delta \lambda_c$ of reflection spectrum of diffraction grating 24 is 3.0 nm. As is well known, the light intensity L rises with a predetermined gradient from the emission threshold current $I_{th}$ with respect to the semiconductor light-emitting device current in the injection current vs. output characteristic. This gradient $\Delta L/\Delta I$ is known as "slope efficiency." In Fig. 12, characteristic Cl indicates the injection current vs. optical output characteristic, whereas characteristic D1 indicates the injection current vs. slope efficiency characteristic.

On the other hand, the oscillation spectrum characteristic, injection current vs. optical output characteristic, and injection current vs. slope efficiency characteristic obtained upon operating a conventional semiconductor laser module using an optical fiber provided with a chirped grating as illustrated in Fig. 13 are shown in Figs. 15 and 16 as mentioned above. The conventional semiconductor laser module used here is one in which a semiconductor light-emitting device for 1.48-$\mu$m band is employed as the semiconductor light-emitting device, the reflectivity $R_c$ of diffraction grating 24 is 3.5%, and the half width $\Delta \lambda_c$ of reflection spectrum of diffraction grating 24 is 7.5 nm. In the conventional semiconductor laser module, a ripple occurs in the oscillation spectrum as shown in Fig. 15, whereby the oscillation spectrum characteristic becomes unstable. Also, a kink occurs in the optical output in the conventional semiconductor laser module when the injection current is gradually increased as shown in Fig. 16, whereby the optical output characteristic becomes unstable.

In the case where the diffraction grating 24 provided in the optical fiber 21 is a chirped grating in which the period of refractive index continuously changes along the light-guiding direction while the distribution of refractive index of this chirped grating changes so as to draw an envelope along the light-guiding direction (Figs. 11 and 12), unlike the case where the diffraction grating provided in the optical fiber 21 is a chirped grating (Figs. 15 and 16), the oscillation wavelength is restrained from fluctuating whereas the occurrence of kinks is suppressed in the injection current vs. optical output characteristic, whereby a stable optical output oscillation spectrum can be obtained, as can be seen when the characteristics shown in Figs. 11 and 12 and those shown in Figs. 15 and 16 are compared with each other.

From the invention thus described, it will be obvious that the embodiments of the invention may be varied in many ways. Such variations are not to be regarded as a departure from the spirit and scope of the invention, and all such modifications as would be obvious to one skilled in the art are intended for inclusion within the scope of the following claims.

**Claims**

1.  A semiconductor laser module comprising a semiconductor light-emitting device for emitting light, and an optical fiber provided with a diffraction grating for reflecting a predetermined wavelength of light in said light emitted from said semiconductor light-emitting device;

    wherein said semiconductor light-emitting device and said optical fiber are optically coupled to each other;
    wherein a light-reflecting surface of said semiconductor light-emitting device and said diffraction grating have a distance therebetween set to a coherence length of said light emitted from said semiconductor light-emitting device or shorter;
    wherein said diffraction grating is a chirped grating; and
    wherein said chirped grating has a refractive index with an amplitude apodized along a light-guiding direction.

2.  A semiconductor laser module according to claim 1, wherein said diffraction grating has a reflection spectrum with a half width of at least 2 nm.

3.  A semiconductor laser module according to claim 2, wherein said diffraction grating has a reflection spectrum with a half width of 6 nm or less.

4.  A semiconductor laser module according to claim 1, wherein said diffraction grating has a reflectivity of at least 1%.

5.  A semiconductor laser module according to claim 1, wherein said diffraction grating is a chirped grating having a period of refractive index at a first position in said light-guiding direction greater than that at a second position which is closer to said semiconductor light-emitting device.

6.  A semiconductor laser module according to claim 1, wherein said optical fiber is a polarization-maintaining optical fiber.

7.  A semiconductor laser module according to claim 1, further comprising connecting means for connecting a package to said optical fiber;

    wherein said connecting means includes a ferrule, attached to said package, for holding said optical fiber; and
    wherein said diffraction grating is provided at a part of said optical fiber which is held within said ferrule.

8.  A semiconductor laser module according to claim 1, wherein said optical fiber has a tip end face on said semiconductor light-emitting device side inclined by a predetermined angle from a plane perpendicular to said light-guiding direction.

9.  A semiconductor laser module according to claim 1, wherein a tip end face of said optical fiber on said semiconductor light-emitting device side is coated with an antireflection film having a reflectivity of 1% or less.

10. A semiconductor laser module according to claim 1, wherein said semiconductor light-emitting device has a light-emitting surface coated with an antireflection film having a reflectivity of at least 0.05% but not exceeding 1%.

11. A semiconductor laser module comprising a semiconductor light-emitting device for emitting light, and an optical fiber provided with a diffraction grating for reflecting a predetermined wavelength of light in said light emitted from said semiconductor light-emitting device;

wherein said semiconductor light-emitting device and said optical fiber are optically coupled to each other;

wherein a light-reflecting surface of said semiconductor light-emitting device and said diffraction grating have a distance therebetween set to a coherence length of said light emitted from said semiconductor light-emitting device or shorter;

wherein said diffraction grating is a chirped grating;

wherein said chirped grating has a refractive index with an amplitude apodized along a light-guiding direction;

wherein said diffraction grating has a reflection spectrum with a half width of at least 2 nm but not exceeding 6 nm;

wherein said diffraction grating has a reflectivity of at least 1%; and

wherein said diffraction grating is a chirped grating having a period of refractive index at a first position in said light-guiding direction greater than that at a second position which is closer to said semiconductor light-emitting device.

12. A semiconductor laser module comprising a semiconductor light-emitting device for emitting light, an optical fiber provided with a diffraction grating for reflecting a predetermined wavelength of light in said light emitted from said semiconductor light-emitting device, and connecting means for connecting a package to said optical fiber;

wherein said connecting means includes a ferrule, attached to said package, for holding said optical fiber;

wherein said diffraction grating is provided at a part of said optical fiber which is held within said ferrule;

wherein said semiconductor light-emitting device and said optical fiber are optically coupled to each other;

wherein a light-reflecting surface of said semiconductor light-emitting device and said diffraction grating have a distance therebetween set to a coherence length of said light emitted from said semiconductor light-emitting device or shorter;

wherein said diffraction grating is a chirped grating;

wherein said chirped grating has a refractive index with an amplitude apodized along a light-guiding direction;

wherein said diffraction grating has a reflection spectrum with a half width of at least 2 nm but not exceeding 6 nm;

wherein said diffraction grating has a reflectivity of at least 1%;

wherein said diffraction grating is a chirped grating having a period of refractive index at a first position in said light-guiding direction greater than that at a second position which is closer to said semiconductor light-emitting device;

wherein a tip end face of said optical fiber on said semiconductor light-emitting device side is coated with an antireflection film having a reflectivity of 1% or less; and

wherein said semiconductor light-emitting device has a light-emitting surface coated with an antireflection film having a reflectivity of at least 0.05% but not exceeding 1%.

# Fig.1

*Fig.2*

*Fig.3*

## Fig.4

OPTICAL OUTPUT FROM SEMICONDUCTOR LIGHT-EMITTING DEVICE [a.u.]

REFLECTIVITY [%]

0    0.1    0.2    0.3    0.4    0.5    0.6    0.7    0.8    0.9    1

## Fig.5

RETURN LOSS [dB]

0    2    4    6    8    10    12

ANGLE θ [° ] FORMED BETWEEN
PLANE PERPENDICULAR TO OPTICAL
AXIS DIRECTION OF OPTICAL FIBER
AND TIP END FACE OF OPTICAL FIBER

# Fig.6

AMOUNT OF AXIAL OFFSET OF 2^{ND} LENS [$\mu$m]

ANGLE $\theta$ [°] FORMED BETWEEN
PLANE PERPENDICULAR TO OPTICAL
AXIS DIRECTION OF OPTICAL FIBER
AND TIP END FACE OF OPTICAL FIBER

# Fig.7

REFRACTIVE INDEX

APODIZATION CURVE

POSITION IN OPTICAL AXIS
DIRECTION OF OPTICAL FIBER

# Fig.8

REFLECTIVITY [%]

6

1

$\Delta \lambda c$

R

R/2

$\lambda c$

WAVELENGTH [nm]

## Fig.9

OPTICAL OUTPUT FROM DIFFRACTION GRATING TO SEMI-CONDUCTOR LIGHT-EMITTING DEVICE [a.u.]

REFLECTIVITY [%]

## Fig.10

OSCILLATION LINE WIDTH [nm]

HALF WIDTH $\Delta\lambda_c$ [nm] OF REFLECTION SPECTRUM OF DIFFRACTION GRATING

## Fig.11

## Fig.12

## *Fig.13*

REFRACTIVE INDEX

POSITION IN OPTICAL AXIS
DIRECTION OF OPTICAL FIBER

## *Fig.14*

REFLECTIVITY [%]

WAVELENGTH [nm]

## Fig.15

## Fig.16